# EUROPEAN PATENT APPLICATION

(11) **EP 0 767 534 A1**
(43) Date of publication of application: **09.04.1997**
(21) Application number: 96115217.0
(22) Date of filing: 23.09.1996
(51) Int. Cl.: H03F 1/30, H03K 5/08

(54) **Signal processing circuit and method**

(30) Priority: 02.10.1995 US 537601
(71) Applicant: MOTOROLA, INC., Schaumburg, IL 60196 (US)
(72) Inventor: Chun, Christopher K. Y., Gilbert, Arizona 85233 (US)
(74) Representative: Spaulding, Sarah Jane

(57) **Abstract**

A signal processing circuit (10) utilizes a threshold circuit (16) to bias a differential output buffer (18). The threshold circuit (16) has a peak detecting circuit (23) that stores a peak value of an input signal on a peak storage element (24). A minimum detecting circuit (26) stores a minimum value of the input signal on a minimum storage element (27). A ratio circuit (30) produces a threshold voltage output (17) that is a ratio of the difference between the peak value and the minimum value.

## Description

### Background of the Invention

The present invention relates, in general, to communication systems, and more particularly, to signal processing circuits for communication systems.

In the past, a variety of design approaches have been utilized to implement signal processing circuits for communication systems, such as receivers for optical communication systems. Typically, such circuits utilize differential amplifiers and have feedback loops in order to implement automatic gain control and automatic offset control within the receivers.

One problem with the prior receivers is the operation during idle time of the burst-mode communication signal applied to the receiver. During idle time, the feedback loop decreases threshold voltage applied to the differential amplifiers thereby causing the receiver to output noise. Additionally, the peak and minimum input voltage values drift over time causing pulse width distortion or even erroneous signals in the output from the receivers.

Accordingly, it is desirable to have a signal processing circuit that does not oscillate, that does not utilize feedback, and that minimizes pulse width distortion in the output signal.

### Brief Description of the Drawings

FIG. 1 schematically illustrates a signal processing circuit in accordance with the present invention; and
FIG. 2 schematically illustrates a circuit implementation of a portion of the signal processing circuit of FIG. 1 in accordance with the present invention.

### Detailed Description of the Drawings

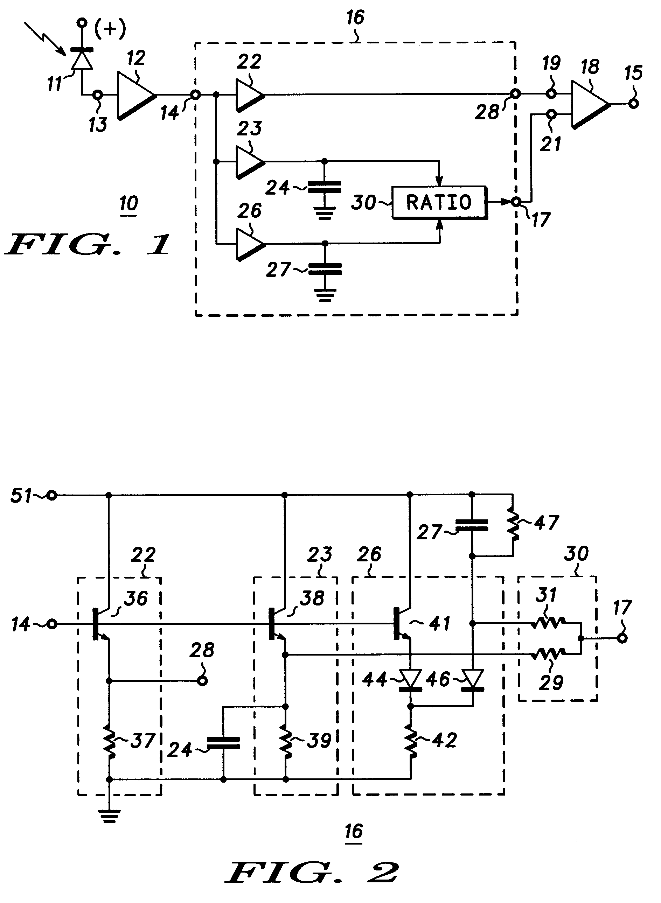

FIG. 1 schematically illustrates a signal processing circuit 10 suitable for receiving burst-mode input signals. Circuit 10 has an input 13 for accepting a received signal. For example, the received signal can original from a photo detector 11 that receives light from a fiber optic cable and converts the light to an electrical signal. Circuit 10 includes a buffer 12 that has an input coupled to input 13 to accept the received signal. Buffer 12 generates an input signal that substantially reproduces the received signal on an output of buffer 12. Buffer 12 typically is either a voltage, current, transimpedance, or transconductance amplifier.

A threshold circuit 16, illustrated by a dashed box, has an input 14 coupled to the output of buffer 12 in order to receive the input signal. Threshold circuit 16 produces a reference voltage on a reference voltage output 17. The reference voltage is utilized to bias a differential output buffer 18. Threshold circuit 16 also produces a shifted signal that is a reproduction of the input signal but shifted in voltage in order to compensate for voltage shifts that occur within circuit 16, as will be explained hereinafter. The shifted signal is provided on a shifted output 28 and is utilized as a signal input to buffer 18.

Threshold circuit 16 includes a peak detecting circuit 23 that applies the peak value of the input signal to a peak storage element 24. Element 24 charges to the peak value of input signal and forms a stored peak value on element 24. A minimum detecting circuit 26 stores the minimum value of the amplified signal on a minimum storage element 27. Element 27 charges to the minimum value of input signal and forms a stored minimum value on element 27. Circuits 23 and 26 each have an input coupled to input 14 in order to receive the input signal. Element 24 has an input that is coupled to an output of circuit 23. Similarly, element 27 has an input coupled to an output of circuit 26 in order to apply the minimum signal value to element 27.

A ratio circuit 30 develops a reference voltage on an output 17. The reference voltage is proportional to the difference between the stored peak value on element 24 and the stored minimum value on element 27. The proportional ratio is selected to minimize pulse width distortion due to distortions in the input signal applied to input 13. In the preferred embodiment, the ratio is approximately one-to-one in order to provide a reference voltage which is substantially centered between the peak value and the minimum value of the input signal in order to accurately reproduce the input signal. Circuit 30 has a first input coupled for receiving the output of element 24 and a second input coupled for receiving the output of element 27.

A level shifter 22 shifts the level of the input signal in order to compensate for level shifts that occur in circuits 23 and 26. Shifter 22 has an input coupled to input 14 and has an output that is also output 28 of circuit 16. In the preferred embodiment, circuit 10 is a monolithic integrated circuit, and shifter 22 and circuits 23 and 26 are matched in order to ensure adequate reproduction of the input signal.

Differential output buffer 18 has an input 19 that is coupled to output 28 in order to receive the input signal that has been processed by buffer 12 and shifter 22. Buffer 18 also has an input 21 that is coupled to output 17 in order to receive the reference voltage that is produced by circuit 16. Because the stored peak and minimum values track the input signal, the reference voltage developed by circuit 30 also tracks changes in the input signal. Consequently, buffer 18 produces a signal on an output 15 that accurately reproduces the input signal applied to input 14. Output 15 can be either a single ended output as illustrated in FIG. 1, or a differential output.

FIG. 2 schematically illustrates an embodiment of a circuit that is suitable for implementing threshold circuit 16 illustrated in FIG. 1. Elements of FIG. 2 that have the same reference numerals as FIG. 1 are the same as the corresponding FIG. 1 elements. Peak detecting circuit 23 utilizes an emitter follower 38 having a base connected to input 14 and a resistor 39 in series with the emitter of transistor 38. Storage element 24 is a capacitor connected in parallel with resistor 39. Minimum detecting circuit 26 utilizes an emitter follower 41 also having a base connected to input 14. The emitter of emitter follower 41 is connected in series with a diode 44 which is in series with a resistor 42. Minimum storage element 27 has one terminal connected to a positive power supply terminal 51, and a second terminal connected in series with a diode 46 that is connected to resistor 42. Diode 46 substantially matches diode 44 and ensures that the voltage on the anode of diode 46 is substantially equal to the voltage on the anode of diode 44. A discharge resistor 47 is in parallel with element 27 to insure that element 27 can be discharged. Shifter 22 also is implemented as an emitter follower 36 with a resistor 37 in series with the emitter thereof.

Ratio circuit 30 utilizes two resistors as a voltage divider connected in series between the output of circuit 26 and the output of circuit 23. A peak ratio element or resistor 29 is connected to element 24 and a minimum ratio element or resistor 31 is connected to element 27. Consequently, the reference voltage on output 17 is proportional to or a ratio of the difference between the output of circuits 23 and 26 wherein the proportion is the ratio of the voltage divider formed by resistors 29 and 31.

By now it should be appreciated that there has been provided a novel signal processing circuit and method. By utilizing a peak detecting circuit and storage element that tracts the peak value of the input signal, and a minimum detecting circuit and storage element that tracts the minimum value of the input signal ensures the threshold voltage also tracks the input signal. Additionally, the threshold voltage will track variations in the input signal over time thereby adjusting for degradation in the signal values. The tracking also minimizes pulse width distortions due to signal variations. The threshold circuit eliminates the need for feedback signals which can cause oscillations thereby improving the reproduction of the input signal applied to the signal processing circuit.

## Claims

1. A signal processing method comprising:
receiving an input signal;
applying a peak value of the input signal to a peak storage element (24) to form a stored peak value;
applying a minimum value of the input signal to a minimum storage element (27) to form a stored minimum value;
generating a reference voltage that is a percentage of a difference between the stored peak value and the stored minimum value; and
using the reference voltage for biasing an amplifier that is receiving the input signal.

2. The method of claim 1 wherein applying the peak value of the input signal to the peak storage element (24) to form the stored peak value includes applying the input signal to a peak detecting circuit (23) and applying an output of the peak detecting circuit (23) to the peak storage element (24).

3. The method of claim 1 wherein applying the minimum value of the input signal to the minimum storage element (27) to form the stored minimum value includes applying the input signal to a minimum detecting circuit (26) and applying an output of the minimum detecting circuit (26) to the minimum storage element (27).

4. The method of claim 1 wherein generating the reference voltage that is the percentage of the difference between the stored peak value and the stored minimum value includes applying the peak stored value and the stored minimum value to a ratio element (30).

5. The method of claim 1 wherein generating the reference voltage that is the percentage of the difference between the stored peak value and the stored minimum value includes applying the peak stored value and the stored minimum value to a voltage divider.

6. A signal processing circuit comprising:
a peak storage element (24) having an output wherein a peak value of an input signal is stored by the peak storage element (24);
a minimum storage element (27) having an output wherein a minimum value of the input signal is stored by the minimum storage element (27);
a ratio circuit (30) for receiving the output of the peak storage element (24) and the output of the minimum storage element (27), the ratio circuit (30) providing a reference voltage that is proportional to a difference between a value of the output of the peak storage element (24) and a value of the output of the minimum storage element (27); and
a differential output buffer (18) for receiving the input signal and the reference voltage wherein the differential output buffer uses the reference voltage for biasing.

7. The circuit of claim 6 wherein the ratio circuit (30) is a voltage divider.

8. The circuit of claim 6 further including a peak detecting circuit for applying the peak value of the input signal to the peak storage element (24).

9. The circuit of claim 6 further including a minimum detecting circuit (26) for applying the minimum value of the input signal to the minimum storage element (27).

10. A signal processing circuit comprising:
a peak detecting circuit (23) having an input for receiving an input signal, and an output;
a peak storage element (24) having an input coupled to the output of the peak detecting circuit (23), and an output;
a minimum detecting circuit (26) having an input for receiving the input signal, and an output;
a minimum storage element (27) having an input coupled to the output of the minimum storage element (27), and an output;
a peak ratio element (29) having an input coupled to the output of the peak storage element (24), and an output coupled to a reference voltage output;
a minimum ratio element (31) having an input coupled to the output of the minimum storage element (27), and an output coupled to the reference voltage output;
a level shifter (22) for receiving the input signal, and a shifted output; and
a differential output buffer (18) having a first input coupled to the shifted output, a second input coupled to the reference voltage output, and an output.
